# EUROPEAN PATENT APPLICATION

(11) **EP 2 515 327 A1**
(43) Date of publication of application: **24.10.2012**
(21) Application number: 11305473.8
(22) Date of filing: 20.04.2011
(51) Int. Cl.: H01L 21/311

(54) **Method for etching a BST layer**

(71) Applicant: STMicroelectronics (Tours) SAS, 37100 Tours (FR); STMicroelectronics Srl, 20864 Agrate Brianza (IT)
(72) Inventor: Caro, Vincent, 37550, SAINT AVERTIN (FR); Rodilosso, Davide, 95127, CATANIA (IT)
(74) Representative: de Beaumont, Michel

(57) **Abstract**

The invention concerns a method for etching a PVD deposited barium strontium titanate (BST) layer, wherein a non-ionic surfactant at a concentration between 0.1 and 1 percent is added to an acid etching solution.

## Description

### FIELD OF THE INVENTION

The present invention relates to a method of etching a ferroelectric material. It more specifically relates to a method for etching a barium strontium titanate layer (BST), used in the fabrication of tunable capacitors.

### BACKGROUND OF THE INVENTION

In some specific structures, there is a need for the fabrication of tunable capacitors, the capacitance of which varies as a function of the applied voltage. To manufacture such capacitors, it has been proposed to use barium strontium titanate, (BaSr)TiO₃, or BST, as a dielectric.

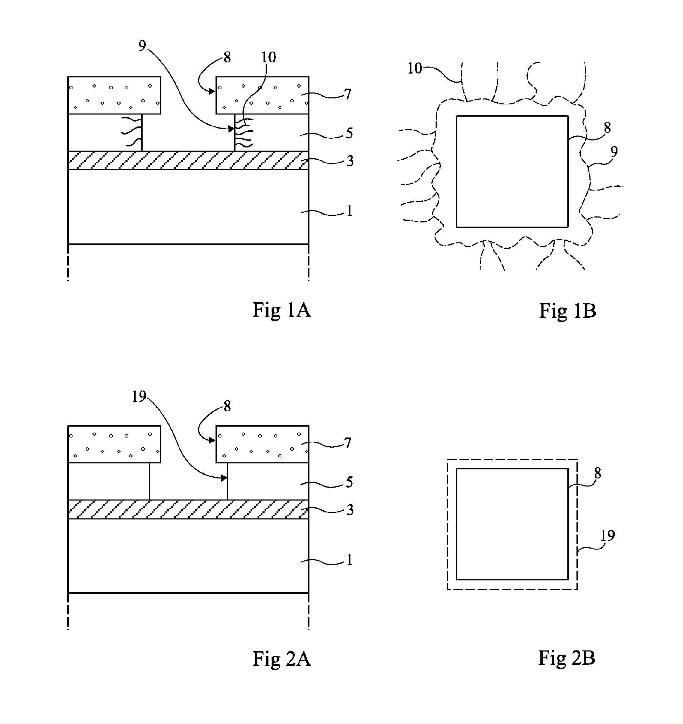

Figure 1A shows such a capacitor during an intermediate manufacturing step. On a substrate 1 is formed a metallic layer 3, generally in platinum. On this layer, a BST layer 5 has been deposited, itself covered with a photoresist 7, in which an opening 8 has been formed by photolithography at the position where it is desired to form an opening 9 in the BST layer.
Figure 1A shows the structure after photolithography of layer 7 and etching of layer 5. Figure 1B is a top view of the structure at this step. The etching of the BST layer is conventionally performed using an acid etching solution of hydrofluoric acid and nitric acid. It can be noticed that the etching of the BST layer 5 suffers from several drawbacks. Firstly, the etching extends relatively far laterally under the photoresist layer 7. The lateral etching may extend under layer 7 by up to five times the thickness of the BST layer. Secondly, this lateral etching is irregular, as shown in Figure 1B, and some cracks 10 extend from the edge of the opening 9 into the BST layer. These cracks are responsible for infiltrations and may damage the dielectric properties of the BST layer where they appear. As a result, a capacitor manufactured in this way does not present the characteristics that should be expected.

### SUMMARY OF THE INVENTION

An object of an embodiment of the present invention is to solve at least one of the drawbacks of the conventional methods of etching a BST layer.

A more specific embodiment of the present invention provides an etching solution providing a regular etching of a BST layer.

Thus, an embodiment of the present invention provides a method for etching a PVD deposited barium strontium titanate (BST) layer, wherein a non-ionic surfactant at a concentration between 0.1 and 1 percent is added to an acid etching solution.

According to an embodiment, the concentration of the surfactant is between 0.2 and 0.4 percent.

According to an embodiment, the etching solution is an aqueous solution of hydrofluoric acid and nitric acid.

According to an embodiment, the surfactant is alkyl-phenoxy-polyglycidol.

According to an embodiment, the BST layer lies on a platinum layer.

An embodiment of the present invention provides a tunable capacitor with a BST dielectric obtained by the above method.

### BRIEF DESCRIPTION OF THE DRAWINGS

The foregoing and other purposes, features, aspects and advantages of the invention will become apparent from the following detailed description of embodiments, given by way of illustration and not limitation with reference to the accompanying drawings, wherein:
Figure 1A, previously described, illustrates schematically an etched BST layer;
Figure 1B, previously described, is a top view of the etched BST layer of Figure 1A;
Figure 2A illustrates schematically an etched BST layer;
Figure 2B is a top view of the etched BST layer of Figure 2A.

For clarity, the same elements have been designated with the same reference numerals in the different drawings, and furthermore, as is usual in the representation of semiconductor components, the various drawings are not to scale.

### DETAILED DESCRIPTION OF THE INVENTION

Figure 2A is a cross section illustrating a tunable capacitor during an intermediate manufacturing step. On a substrate 1, which is for example made of glass, sapphire, alumina, quartz or which is a silicon substrate covered with an isolating layer that constitutes the top layer of a structure, is formed a layer 3 in platinum that will form the lower electrode of the capacitor. On this layer, a sputtered BST film 5 has been formed by physical vapor deposition (PVD), itself covered with a photoresist layer 7, in which an opening 8 has been formed by photolithography at the position where it is desired to form an opening 19 in the BST layer.

Figure 2A shows the structure after photolithography of layer 7 and etching of layer 5. Figure 2B is a top view of the structure at this particular step. The etching of the BST layer has been performed by an acid etching solution that is a mixture of hydrofluoric acid and nitric acid in an aqueous solution, into which a non-ionic surfactant has been added. The surfactant is for example alkyl-phenoxy-polyglycidol, at a concentration between 0.1 and 1 percent, preferably between 0.2 and 0.4 percent in volume. The etching solution is for example obtained from a mixture of 1.6 liters of HF at a concentration of 1 percent, 0.14 liter of HNO₃ at a concentration of 70 percent and 26.25 liters of water.

The lateral etching of the BST layer is regular, as shown schematically by Figure 2B, and the amount that this lateral etching of the BST layer extends under the photoresist layer 7 is roughly reduced by a factor 2 compared to the use of the same etching solution without surfactant. Additionally, no cracks 10 appear in the BST layer from the edge 19 of the opening formed in this BST layer.

Moreover, the inventors observed that the addition of a surfactant in the acid etching solution has no influence on the etch rate of the BST layer compared to the use of the same etching solution without surfactant. It is considered that the conservation of the etch rate is related to the conservation of the acidity levels of the etching solution thanks to the non-ionic nature of the surfactant used.

By conserving the BST etch rate as compared to the use of the same etching solution without surfactant, the man skilled in the art is able to re-use the know-how concerning the etching of the BST layer, while taking advantage of the benefits related to the method described herein.

The improvement in the lateral etching (thinner and more regular) is attributed to the fact that the surfactant forms aggregates (for example micelles), that obstruct the edge of the etching area under the photoresist layer.

For example, the dimensions of the opening in the photoresist layer may be chosen such that the opening in the BST layer is between several micrometers and several hundred micrometers across.

The invention is subject to various modifications, in particular as regards the acids usable for the etching solution. Various surfactants can also be used. The metallic layer 3 that supports the BST layer and will form the lower electrode of the capacitor can be formed in a metal other than platinum. However, it will be noted that the invention specifically applies to BST layers deposited by PVD, and not to BST layers resulting from a solgel coating.

## Claims

1. A method for etching a PVD deposited barium strontium titanate (BST) layer, wherein a non-ionic surfactant at a concentration between 0.1 and 1 percent is added to an acid etching solution.

2. The method of claim 1, wherein the concentration of the surfactant is between 0.2 and 0.4 percent.

3. The method of claim 1 or 2, wherein the etching solution is an aqueous solution of hydrofluoric acid and nitric acid.

4. The method of any of claims 1 to 3, wherein the surfactant is alkyl-phenoxy-polyglycidol.

5. The method of any of claims 1 to 4, wherein the BST layer lies on a platinum layer.

6. A tunable capacitor with a BST dielectric obtained by the method of any of claims 1 to 5.
